# DEMANDE DE BREVET EUROPEEN

(11) **EP 1 220 447 A1**
(43) Date de publication de la demande: **03.07.2002**
(21) Numéro de dépôt: 01402793.2
(22) Date de dépôt: 26.10.2001
(51) Int. Cl.: H03J 1/00, H03J 7/08

(54) **Procédé et dispositif de calage en fréquence d'un récepteur de signaux radioélectrique**

(30) Priorité: 03.11.2000 FR 0014132
(71) Demandeur: ATRAL, F-38190 Crolles (FR)
(72) Inventeur: Laurens, Gaston, 38570 Le Cheylas (FR); Cariou, Laurent, 38240 Meylan (FR)
(74) Mandataire: Casalonga, Axel

(57) **Abrégé**

Procédé et dispositif de réception de signaux radioélectriques comprenant un récepteur comprenant une antenne et un circuit de réception présentant une sortie de signal reçu, des moyens d'échantillonage permettant de conférer au récepteur des phases de réception séparées par des phases d'absence de réception, dans lesquels des moyens de réglage (13) permettant de faire fonctionner le circuit de réception (2) sur des fréquences de fonctionnement particulières ; un générateur (15) délivre un signal de référence sur une fréquence nominale ; des moyens de scrutation (23) agissent sur les moyens de réglage de façon à ce que le circuit de réception fonctionne, pendant une période de scrutation, successivement sur des fréquences incluant la fréquence nominale ; des moyens de pilotage (19) divisent la période de scrutation en phases de scrutation (Ps) dont la durée de chacune est au plus égale à la durée des phases d'absence de réception dudit circuit de réception et mettent en action le générateur et les moyens de scrutation pendant ces phases de scrutation ; des moyens de détection (21) détectent l'amplitude du signal issu du circuit de réception pendant les phases de scrutation ; et des moyens (19) agissent sur lesdits moyens de réglage pour fixer une nouvelle fréquence de fonctionnement dudit circuit de réception.

## Description

La présente invention a pour objet un procédé et un dispositif pour réaliser le calage ou le réglage en fréquence d'un récepteur de signaux radioélectriques.

Actuellement, le calage ou le réglage de la fréquence d'accord d'un récepteur de signaux radioélectriques est réalisé soit à l'aide de composants ajustables à la fabrication soit automatiquement au cours de son utilisation en utilisant une fréquence de référence provenant d'un émetteur dont la stabilité correspond à la précision de calage recherchée.

Dans le premier cas, le vieillissement du récepteur et les variations des caractéristiques des composants le constituant, dus en particulier aux variations de température et d'hygrométrie de l'endroit où ce récepteur est installé, entraînent des variations de sa fréquence d'accord par rapport à la fréquence d'accord réglée à la fabrication.

Dans le second cas, le récepteur est placé périodiquement en périodes de calage pendant lesquelles il n'est plus apte à recevoir des signaux extérieurs.

La présente invention vise à rémédier aux inconvénients exposés ci-dessus.

La présente invention a tout d'abord pour objet un procédé de calage en fréquence d'un récepteur de signaux radioélectriques comprenant une antenne et un circuit de réception présentant une sortie de signal reçu, dans lequel des moyens d'échantillonage permettent de conférer au circuit de réception des phases de réception séparées par des phases d'absence de réception aux signaux radioélectriques.

Le procédé selon l'invention consiste :
- à faire fonctionner le récepteur sur une fréquence de réception particulière au cours desdites phases de réception ;
- à générer une période de scrutation divisée en phases de scrutation incluses dans des phases d'absence de réception du circuit de réception et à délivrer un signal de référence, émis sur une fréquence nominale, à l'entrée du circuit de réception pendant ces phases de scrutation ;
- à faire varier, au cours desdites phases de scrutation, la fréquence de fonctionnement du circuit de réception et à détecter l'amplitude du signal de scrutation apparaissant à la sortie du circuit de réception ;
- à fixer une nouvelle fréquence de fonctionnement dudit circuit de réception correspondant à une amplitude du signal de scrutation ;
- à placer le circuit de réception sur cette nouvelle fréquence de fonctionnement particulière au cours d'une phase ultérieure d'absence de réception de ce circuit de réception puis à faire fonctionner le récepteur sur cette nouvelle fréquence de réception particulière au cours de ses périodes ultérieures de réception.

Le procédé selon l'invention peut avantageusement consister à fixer une nouvelle fréquence de fonctionnement dudit circuit de réception correspondant à celle pour laquelle l'amplitude du signal de scrutation est maximum ou proche de son maximum.

Le procédé selon l'invention peut avantageusement consister à déconnecter l'antenne du circuit de réception au cours desdites phases de scrutation et à connecter à ce circuit de réception un générateur du signal de référence à la fréquence nominale précitée.

La présente invention a également pour objet un dispositif de réception de signaux radioélectriques comprenant un récepteur comprenant une antenne et un circuit de réception présentant une sortie de signal reçu, des moyens d'échantillonage permettant de conférer au récepteur des phases de réception séparées par des phases d'absence de réception.

Selon l'invention, ce dispositf comprend :
- des moyens de réglage permettant de faire fonctionner le circuit de réception sur des fréquences de fonctionnement particulières ;
- un générateur de signal de référence sur une fréquence nominale ;
- des moyens de scrutation adaptés pour agir sur les moyens de réglage de façon à ce que le circuit de réception fonctionne, pendant une période de scrutation, successivement sur des fréquences d'une bande de fréquences incluant la fréquence nominale ;
- des moyens de pilotage divisant la période de scrutation en phases de scrutation dont la durée de chacune est au plus égale à la durée des phases d'absence de réception dudit circuit de réception et mettant en action le générateur de signaux et les moyens de scrutation pendant ces phases de scrutation ;
- des moyens de détection pour détecter l'amplitude du signal apparaissant à la sortie du circuit de réception pendant les phases de scrutation ;
- et des moyens agissant sur lesdits moyens de réglage pour fixer une nouvelle fréquence de fonctionnement dudit circuit de réception correspondant à une amplitude du signal de scrutation.

Le dispositif selon l'invention peut avantageusement comprendre des moyens de connexion/déconnexion, soumis auxdits moyens de pilotage pour déconnecter l'antenne du circuit de réception et connecter le générateur de signal de référence à ce circuit de réception pendant les phases de scrutation.

Selon l'invention, lesdits moyens de connexion/déconnexion comprennent de préférence un commutateur à deux voies.

Selon l'invention, lesdits moyens de réglage comprennent de préférence un condensateur à capacité variable.

Le dispositif selon l'invention peut avantageusement comprendre des moyens pour couper/établir l'alimentation du circuit de réception, ces moyens étant soumis auxdits moyens de pilotage pour établir ou maintenir l'alimentation du circuit de réception pendant les phases de scrutation précitées.

La présente invention sera mieux comprise à l'étude de dispositifs de calage en fréquence de récepteurs de signaux radioélectriques et de leurs procédés de fonctionnement, décrits à titre d'exemples non limitatifs et illustrés par le dessin sur lequel :
- la figure 1 représente un dispositif de réception de signaux radioélectriques incluant un circuit de réception à super-réaction ;
- la figure 2 représente le schéma électronique d'un dispositif de réception de signaux radioélectriques incluant un circuit de réception super-hétérodyne ;
- et la figure 3 représente un organigramme de fonctionnement des dispositifs précités.

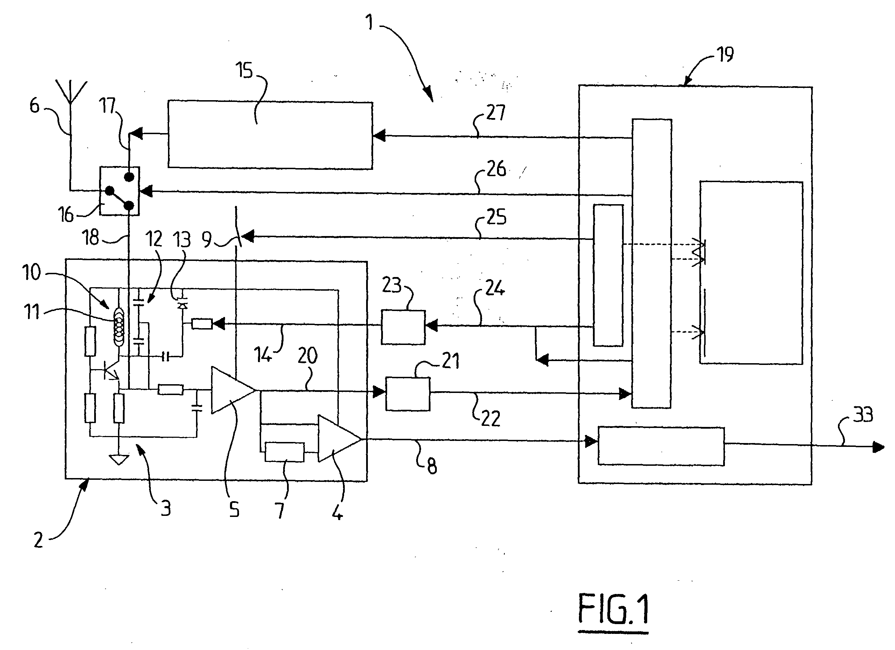

En se reportant à la figure 1, on voit qu'on a représenté un dispositif de réception 1 de signaux radioélectriques qui inclut un récepteur à super-réaction 2.

Ce récepteur 2 à super-réaction comprend un circuit oscillateur à super-réaction 3 susceptible de délivrer à une entrée d'un comparateur 4, via un amplificateur 5, un signal représentatif d'un signal radioélectrique capté par une antenne 6, l'autre entrée du comparateur 4 étant soumise à un seuil 7 de telle sorte que le comparateur 4 délivre un signal numérique sur la sortie 8 de signal reçu du circuit de réception 2.

Le circuit de réception 2 est susceptible d'être alimenté par une source d'énergie électrique non représentée, le pôle (+) de cette alimentation étant relié au circuit de réception par l'intermédiaire d'un interrupteur 9 commandable.

L'oscillateur à super-réaction 3, par ailleurs construit de façon habituelle et agencé dans l'exemple représenté en quench externe, comprend un circuit bouchon 10 qui comprend, montés en parallèle, une self 11 et un montage 12 de condensateurs.

De façon connue en soi, ce sont principalement les caractéristiques du circuit bouchon 12 qui déterminent la fréquence d'oscillations du circuit oscillateur à super-réaction 3 et en conséquence la fréquence de fonctionnement du circuit de réception 2.

Afin de pouvoir faire varier et de régler cette fréquence de fonctionnement, le montage de condensateur 12 comprend un condensateur 13 à capacité variable contrôlé en tension via une ligne d'entrée 14 du circuit de réception 2.

Le dispositif de réception 1 comprend en outre un générateur 15 adapté pour délivrer au circuit de réception 2, par une ligne filaire, un signal de référence sur une fréquence nominale déterminée correspondant à la fréquence sur laquelle des signaux radioélectriques sont attendus pour être captés par l'antenne 6.

Afin de relier sélectivement l'antenne 6 et le générateur 15 au circuit de réception 12, le dispositif de réception 1 comprend un commutateur 16 commandable. Pour celà, l'antenne 6 est reliée à l'un des points de contact du commutateur 16, la sortie du générateur 15 est reliée à l'autre point de contact du commutateur 16 par une ligne 17 et le point commun de l'amplificateur 16 est relié à l'oscillateur à super-réaction 3 par une ligne 18.

Le dispositif de réception 1 comprend en outre, une unité électronique 19 de traitement de signaux numériques et de pilotage, montée de la manière suivante.

L'unité électronique 19 comprend une entrée sur laquelle est branchée la ligne 8 issue de la sortie de signal reçu du comparateur 4.

La sortie de l'amplificateur 5 est reliée à une sortie du circuit de réception 2 par une ligne 20 qui est reliée à l'entrée d'un circuit de conversion A/D (analogique/digital) 21 dont la sortie est reliée à une entrée de l'unité électronique 19 par une ligne de scrutation 22.

Une sortie de réglage de l'unité électronique 19 est reliée à une entrée d'un convertisseur D/A (digital/analogique) 23 par une ligne 24, la sortie de ce convertisseur D/A 23 étant reliée à la ligne 14 de contrôle en tension du condensateur variable 13.

Une sortie de commande de l'unité électronique 19 est reliée à l'entrée de commande de l'interrupteur 9 par une ligne 25.

Une sortie de commande de l'unité électronique 19 est reliée à l'entrée de commande du commutateur 16 par une ligne 26.

Une sortie de commande de l'unité électronique 19 est reliée à l'entrée de commande du générateur 15 par une ligne 27.

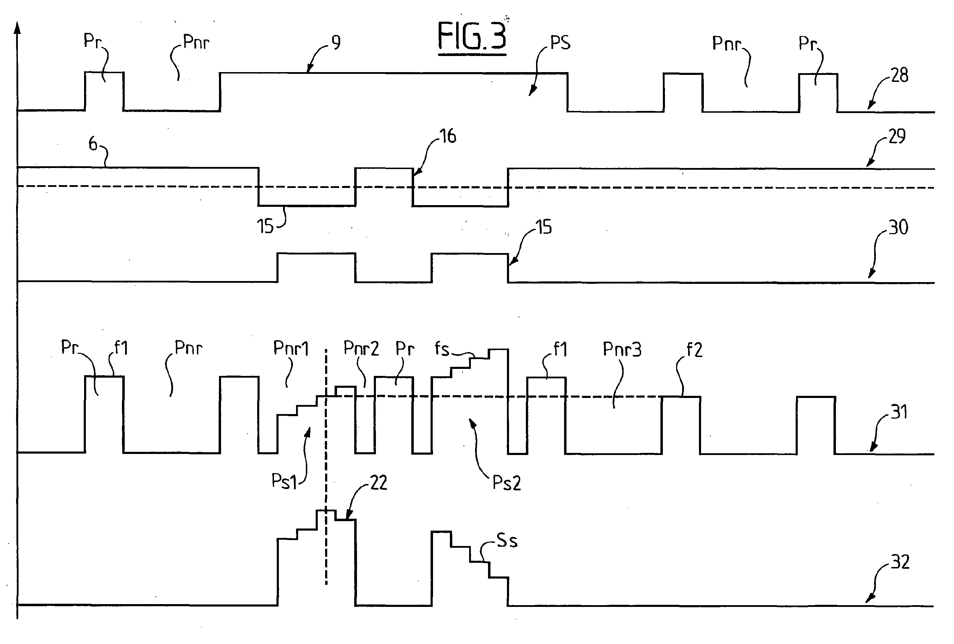

En se reportant aux figures 1 et 3, on va maintenant décrire comment fonctionne le dispositif de réception 1.

Pour celà, on voit qu'on a représenté sur la figure 3 un diagramme 28 de fonctionnement de l'interrupteur 9, un diagramme 29 de fonctionnement du commutateur 16, un diagramme 30 de fonctionnement du générateur 15, un diagramme 31 de fonctionnement du circuit de réception 2 et un diagramme 32 de signaux de scrutation délivrés à l'unité électronique 19 par la ligne 22.

En fonctionnement courant, l'unité électronique 19 délivre par la ligne 24 un signal constant de réglage au convertisseur D/A 23 dont la sortie impose au condensateur à capacité variable 13 une tension déterminée fixant ainsi une fréquence de fonctionnement f1 déterminée du circuit oscillateur 3 à super-réaction et en conséquence du circuit de réception 2.

Afin en particulier de réduire la consommation en énergie électrique, l'unité électronique 19 commande l'interrupteur 9 de façon à générer des phases de réception Pr pendant lesquelles l'interrupteur 9 est placé en position fermée de telle sorte que le circuit de réception 2 est alimenté en énergie électrique, séparé par des phases d'absence de réception Pnr pendant lesquelles le circuit de réception 2 n'est pas alimenté en énergie électrique.

Au cours de ces phases courantes visibles sur les diagrammes 28 et 31, l'unité électronique 19 commande le commutateur 16 de façon à relier l'antenne 6 au circuit oscillateur à super-réaction 3.

Le générateur 15 n'étant pas en service pendant ces phases courantes, l'unité électronique 19 pourrait commander le commutateur 16 de façon à déconnecter l'antenne 6 du circuit de réception 2 pendant les phases d'absence de réception Pnr afin de réduire d'éventuelles ré-émissions par l'antenne 6.

Au cours des phases de réception Pr, l'unité électronique 19 analyse les signaux issus du comparateur 4 sur la ligne 8, qui sont représentatifs des signaux radioélectriques captés par l'antenne 6, et délivre éventuellement des signaux de commande par une ligne de sortie 33.

A des moments déterminés relativement espacés, l'unité électronique 19 génère des périodes de scrutation PS permettant d'analyser l'état fonctionnel du circuit de réception 2 et en particulier du circuit oscillateur à super-réaction 3, la durée de chaque période de scrutation étant plus grande que la durée de chaque phase d'absence de réception Pnr.

Pour celà, dans l'exemple décrit, l'unité électronique 19 divise la période de scrutation PS en deux phases de scrutation Ps1 et Ps2 dont la durée de chacune est inférieure à la durée de chaque phase d'absence de réception Pnr pour pouvoir ainsi être incluses dans deux phases d'absence de réception Pnr1 et Pnr2 successives comme le montre le diagramme 31.

Au cours de cette période de scrutation PS, l'unité électronique 19 maintient l'interrupteur 9 à sa position fermée de manière à maintenir l'alimentation du circuit de réception 2 pendant les phases d'absence de réception Pnr1 et Pnr2 et en conséquence pendant toute la période de scrutation comme le montre le diagramme 28.

Pendant les phases de scrutation Ps1 et Ps2 incluses, dans l'exemple décrit, dans deux phases d'absence de réception Pnr1 et Pnr2 successives, l'unité électronique 19 fonctionne de la manière suivante.

Comme le montre le diagramme 29, l'unité électronique 19 commande le commutateur 16 de façon à relier le générateur 15 au circuit oscillateur à super-réaction 3 par les lignes 17 et 18.

Comme le montre le diagramme 30, l'unité électronique 19 met ce générateur 15 en fonctionnement de telle sorte que le signal de référence à une fréquence nominale déterminée, délivré par ce générateur 15, sollicite le circuit de réception 2 via le commutateur 16.

Comme le montre le diagramme 31, l'unité électronique 19 commande le convertisseur D/A 23 de façon à ce que ce dernier délivre des signaux de réglage Sr faisant varier la tension de contrôle du condensateur 13 à capacité variable par paliers et en conséquence la fréquence de fonctionnement du circuit de réception 2 selon des fréquences de scrutation fs incluant la fréquence nominale précitée.

En même temps, l'unité électronique 19 analyse l'amplitude du signal de scrutation Ss que lui communique le convertisseur A/D 21 via la ligne 22 et qui est issue du circuit oscillateur à super-réaction 3 via l'amplificateur 5.

L'unité électronique 19 recherche alors la valeur du signal de réglage Srm pour laquelle l'amplitude du signal de scrutation Ss est maximum ou approximativement maximum.

A partir de la phase d'absence de réception Pnr 3 suivante et jusqu'à la période de scrutation PS suivante, l'unité électronique 19 délivre le nouveau signal de réglage Srm au convertisseur D/A 23 de façon à ce que ce dernier place le circuit de réception 2 sur la nouvelle fréquence de fonctionnement f2 associée à la nouvelle tension de contrôle de la capacité du condensateur 13 à capacité variable.

Bien entendu, la période de scrutation PS pourrait être divisée en plus de deux phases de scrutation Ps, incluses dans autant de phases d'absence de réception Pnr que nécessaires en fonction du nombre de fréquences de scrutation fs appliquées et de la durée de leur application. Ces phases de scrutation Ps pourraient être suivies en outre d'une phase de scrutation à paliers réduits de façon à affiner la valeur du signal de réglage Sr de la nouvelle fréquence de fonctionnement f2 à appliquer.

Il résulte de ce qui vient d'être décrit que la période de scrutation PS divisée en phases de scrutation Ps incluses dans les phases d'absence de réception Pnr du circuit de réception 2 ne perturbe pas les capacités de réception du circuit de réception 2.

En effet, le circuit de réception 2 continue de présenter des phases de réception Pr pendant la période de scrutation Ps de telle sorte que des signaux captés par l'antenne 6 pendant cette période de scrutation PS au cours des phases de réception Pr incluses dans cette période de scrutation PS sont susceptibles d'être reçus et traités par l'unité électrique 19.

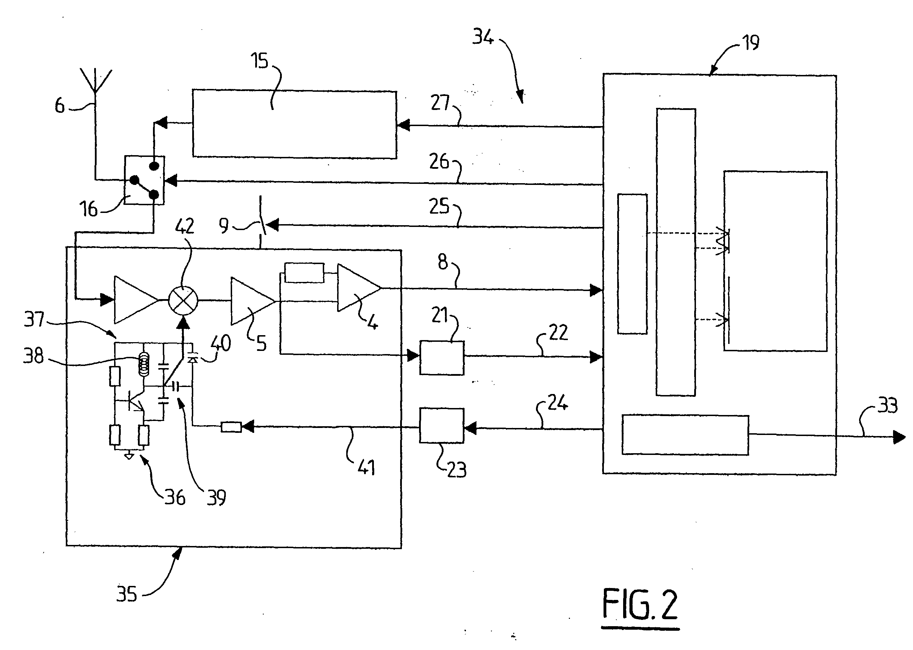

En se reportant à la figure 2, on voit qu'on a représenté un dispositif de réception 34 qui se différencie du dispositif de réception décrit en référence à la figure 1 uniquement par le fait qu'il comprend un circuit de réception 35 super-hétérodyne à structure générale connue en soi.

Ce circuit de réception 35 comprend un circuit oscillateur 36 dont la fréquence d'oscillation est également déterminée par un circuit bouchon 37 qui comprend une self 38 et un montage 39 de condensateurs incluant un condensateur 40 à capacité variable contrôlé en tension via une ligne 41 reliée à la sortie du convertisseur D/A 23.

Le signal issu de l'oscillateur local 36 et le signal issu de l'antenne 6 ou du générateur 15 via le commutateur 16 sont délivrés à un mélangeur 42 dont la sortie est reliée, comme dans l'exemple précédent, à l'amplificateur 5 dont la sortie est reliée d'une part à la ligne 8 via le comparateur 4 et d'autre part à l'entrée du convertisseur A/D 21.

Le dispositif de réception 34 peut ainsi fonctionner de la même manière que le dispositif de réception 1, de telle sorte que l'unité électronique 19 puisse piloter la tension de contrôle du condensateur 40 à capacité variable afin de régler périodiquement la fréquence de fonctionnement du circuit de réception super-hétérodyne 35, sans perturber ses phases de réception .

La présente invention ne se limite pas aux dispositifs de réception 1 et 34 décrits ci-dessus. Bien des variantes de réalisation sont possibles, en particulier en ce qui concerne la structure proprement dite des circuits de réception, connus en soi, qui pourrait dépendre des signaux radioélectriques à recevoir et des besoins de traitement par l'unité électronique 19 des signaux reçus correspondants. En outre, l'organe permettant de faire varier et de régler leur fréquence de fonctionnement pourrait être différent.

## Revendications

1. Procédé de calage en fréquence d'un récepteur de signaux radioélectriques comprenant une antenne et un circuit de réception présentant une sortie de signal reçu, dans lequel des moyens d'échantillonage permettent de conférer au circuit de réception des phases de réception séparées par des phases d'absence de réception de signaux radioélectriques, **caractérisé par le fait qu'**il consiste :
- à faire fonctionner le récepteur sur une fréquence de réception particulière (f1) au cours desdites phases de réception (Pr) ;
- à générer une période de scrutation (PS) divisée en phases de scrutation (Ps) incluses dans des phases d'absence de réception (Pnr) du circuit de réception (2) et à délivrer un signal de référence, émis sur une fréquence nominale, à l'entrée du circuit de réception pendant ces phases de scrutation ;
- à faire varier, au cours desdites phases de scrutation, la fréquence de fonctionnement du circuit de réception (2) et à détecter l'amplitude du signal de scrutation (Ss) apparaissant à la sortie du circuit de réception ;
- à fixer une nouvelle fréquence de fonctionnement (f2) dudit circuit de réception correspondant à une amplitude du signal de scrutation ;
- à placer le circuit de réception sur cette nouvelle fréquence de fonctionnement particulière au cours d'une phase ultérieure d'absence de réception de ce circuit de réception puis à faire fonctionner le récepteur sur cette nouvelle fréquence de réception particulière au cours de ses périodes ultérieures de réception.

2. Procédé selon la revendication 1, **caractérisé par le fait qu'**il consiste à fixer une nouvelle fréquence de fonctionnement (f2) dudit circuit de réception (2) correspondant à celle pour laquelle l'amplitude du signal de scrutation est maximum ou proche de son maximum.

3. Procédé selon l'une des revendications 1 et 2, **caractérisé par le fait qu'**il consiste à déconnecter l'antenne (6) du circuit de réception au cours desdites phases de scrutation et à connecter à ce circuit de réception un générateur (15) du signal de référence à la fréquence nominale précitée.

4. Dispositif de réception de signaux radioélectriques comprenant un récepteur comprenant une antenne et un circuit de réception présentant une sortie de signal reçu, des moyens d'échantillonage permettant de conférer au récepteur des phases de réception séparées par des phases d'absence de réception, **caractérisé par le fait qu'**il comprend :
- des moyens de réglage (13) permettant de faire fonctionner le circuit de réception (2) sur des fréquences de fonctionnement particulières ;
- un générateur (15) de signal de référence sur une fréquence nominale ;
- des moyens de scrutation (19, 22, 23) adaptés pour agir sur les moyens de réglage de façon à ce que le circuit de réception fonctionne, pendant une période de scrutation, successivement sur des fréquences incluant la fréquence nominale ;
- des moyens de pilotage (19, 23) divisant la période de scrutation en phases de scrutation (Ps) dont la durée de chacune est au plus égale à la durée des phases d'absence de réception dudit circuit de réception et mettant en action le générateur de signaux et les moyens de scrutation pendant ces phases de scrutation ;
- des moyens de détection (21) pour détecter l'amplitude du signal apparaissant à la sortie du circuit de réception pendant les phases de scrutation ;
- et des moyens (19) agissant sur lesdits moyens de réglage pour fixer une nouvelle fréquence de fonctionnement dudit circuit de réception correspondant à une amplitude du signal de scrutation.

5. Dispositif selon la revendication 4, **caractérisé par le fait qu'**il comprend des moyens de connexion/déconnexion (16), soumis auxdits moyens de pilotage pour déconnecter l'antenne du circuit de réception et connecter le générateur de signal de référence à ce circuit de réception pendant les phases de scrutation.

6. Dispositif selon la revendication 5, **caractérisé par le fait que** lesdits moyens de connexion/déconnexion comprennent un commutateur à deux voies (16).

7. Dispositif selon l'une quelconque des revendications 4 à 6, **caractérisé par le fait que** lesdits moyens de réglage (13) comprennent un condensateur à capacité variable.

8. Dispositif selon l'une quelconque des revendications 4 à 7, **caractérisé par le fait qu'**il comprend des moyens (9) pour couper/établir l'alimentation du circuit de réception, ces moyens étant soumis auxdits moyens de pilotage pour établir ou maintenir l'alimentation du circuit de réception pendant les phases de scrutation précitées.
